# EUROPEAN PATENT APPLICATION

(11) **EP 1 175 964 A2**
(43) Date of publication of application: **30.01.2002**
(21) Application number: 01306441.5
(22) Date of filing: 27.07.2001
(51) Int. Cl.: B24B 37/04, B24B 49/14, B24B 57/02

(54) **Polishing surface temperature conditioning system for a chemical mechanical planarization process**

(30) Priority: 27.07.2000 US 626523
(71) Applicant: Agere Systems Guardian Corporation, Orlando, Florida 32819 (US)
(72) Inventor: Crevasse, Annette M., Apopka, Florida 32703 (US); Easter, William G., Orlando, Florida 32837 (US); Maze, John A., Clermont, Florida 34711 (US); Miceli, Frank, Orlando, Florida 32824 (US); Yan, Yifeng Winsten, Orlando, Florida 32837 (US)
(74) Representative: Williams, David John

(57) **Abstract**

The present invention provides a polishing surface temperature conditioning apparatus for use with a polishing system having a polishing surface. In one advantageous embodiment, the polishing surface temperature conditioning apparatus comprises a fluid delivery system coupled to the polishing system and configured to deliver a fluid to a polishing surface of a polishing surface; and a heat exchanger that is coupled to the fluid delivery system and configured to control a fluid temperature of the fluid. The fluid temperature is chosen to effect a surface temperature of the polishing surface.

## Description

### TECHNICAL FIELD OF THE INVENTION

The present invention is directed, in general, to semiconductor wafer processing and, more specifically, to an apparatus and method for preheating a polishing surface after a pad change or a significant period of inactivity.

### BACKGROUND OF THE INVENTION

In the manufacture of integrated circuits (ICs), chemical/mechanical planarization (CMP) is used to provide smooth topographies of semiconductor wafer substrates on which the ICs are formed for subsequent lithography and material deposition. These CMP processes are well known within the IC fabrication industry.

The success of CMP processes are highly dependent on the physical parameters present at the interface between the semiconductor substrate and the polishing surface in contact with the substrate. Among the physical parameters of interest are slurry pH concentration (acid or base), rates of rotation of the polishing surface/polishing platen, the size and composition of the abrasive particle, the pressure applied by the carrier or polishing head to the substrate and polishing platen, and the temperature at the interface of the wafer and polishing surface where the planarization occurs. That temperature will be referred to as the planarization temperature for this discussion. The planarization temperature is significant because it may accelerate or impede the chemical reaction, which is the chemical portion of the CMP. Of course, the friction created by the polishing affects the planarization temperature, i.e., more friction tends to cause a higher planarization temperature and vice versa.

Whenever the polishing surface wears out and is replaced, or the CMP system has been idle for a significant time, the polishing surface reverts to ambient temperature, which for hard metals is lower than the typical planarization temperature. Especially in the planarization of hard metals, such as tungsten, a couple of different attempts have been made to control the planarization temperature. One approach has been to heat the metal polishing platen. This has met with limited success, because the heating of the polishing platen does not adequately heat the polishing surface. This is due to the characteristics of the polishing pad, which is a man-made polymer, effectively acting as an insulator. Therefore, the heat in the platen may not be effectively transmitted to the polishing surface, resulting in the polishing face of the pad being significantly cooler than the platen face of the pad.

The other approach most successfully used has been to employ warm-up or dummy wafers in a polishing process that has a sole purpose of generating a steady-state condition for material removal. This is accomplished by polishing as many as 15 to 20 "dummy" wafers against the polishing surface. This may be accomplished in polishing "groups" ranging from one to five wafers depending upon the capacity of the polisher. However, the cost of this operation in both time and money, is significant. Each dummy wafer, with only a single tungsten film, may cost $200. Therefore, the warm-up wafers, costing $4,000, plus the labor and production polishing downtime, plus slurry at $30 per gallon, could easily exceed $10,000 in cost simply for changing a polishing surface, or leaving the machine idle.

Accordingly, what is needed in the art is an apparatus and method for temperature conditioning the polishing surface while avoiding the problems of the prior art.

### SUMMARY OF THE INVENTION

To address the above-discussed deficiencies of the prior art, the present invention provides a polishing surface temperature conditioning apparatus for use with a polishing system having a polishing surface, such as a conventional polishing pad. In one advantageous embodiment, the polishing surface temperature conditioning apparatus comprises a fluid delivery system that is coupled to the polishing system and that is configured to deliver a fluid to a polishing surface of a polishing surface. The system further includes a heat exchanger that is coupled to the fluid delivery system and that is configured to control a fluid temperature of the fluid. The fluid temperature is chosen to effect a surface temperature of the polishing surface.

Thus, in one aspect, the present invention provides an apparatus to effectively heat the surface of the polishing pad, which, in turn, provides a more consistent and effective polishing process.

In one embodiment, the heat exchanger includes a controller configured to control the fluid temperature. The polishing surface temperature conditioning apparatus may include a temperature sensor coupled to the polishing surface and the heat exchanger with the temperature sensor configured to sense the surface temperature. In a further aspect of this embodiment, the temperature sensor may be: an infrared sensor, a thermocouple, a thermistor, a pyrometer, a liquid/glass thermometer, a pressure thermometer, a resistance thermometer, or a linear quartz thermometer.

In another embodiment, the heat exchanger includes a heater configured to transfer heat to the heat exchanger and the fluid. The heat exchanger, in a complementary embodiment, includes a chiller configured to transfer heat from the heat exchanger and the fluid. In yet another embodiments, the fluid may be a temperature conditioning rinse or a slurry.

The foregoing has outlined, rather broadly, preferred and alternative features of the present invention so that those skilled in the art may better understand the detailed description of the invention that follows. Additional features of the invention will be described hereinafter that form the subject of the claims of the invention. Those skilled in the art should appreciate that they can readily use the disclosed conception and specific embodiment as a basis for designing or modifying other structures for carrying out the same purposes of the present invention. Those skilled in the art should also realize that such equivalent constructions do not depart from the spirit and scope of the invention in its broadest form.

### BRIEF DESCRIPTION OF THE DRAWINGS

For a more complete understanding of the present invention, reference is now made to the following descriptions taken in conjunction with the accompanying drawings, in which:
FIGURE 1 illustrates a partial sectional view of one embodiment of a polishing surface temperature conditioning apparatus constructed according to the principles of the present invention; and
FIGURE 2 illustrates a partial sectional view of an alternative embodiment of the polishing surface temperature conditioning apparatus of FIGURE 1.

### DETAILED DESCRIPTION

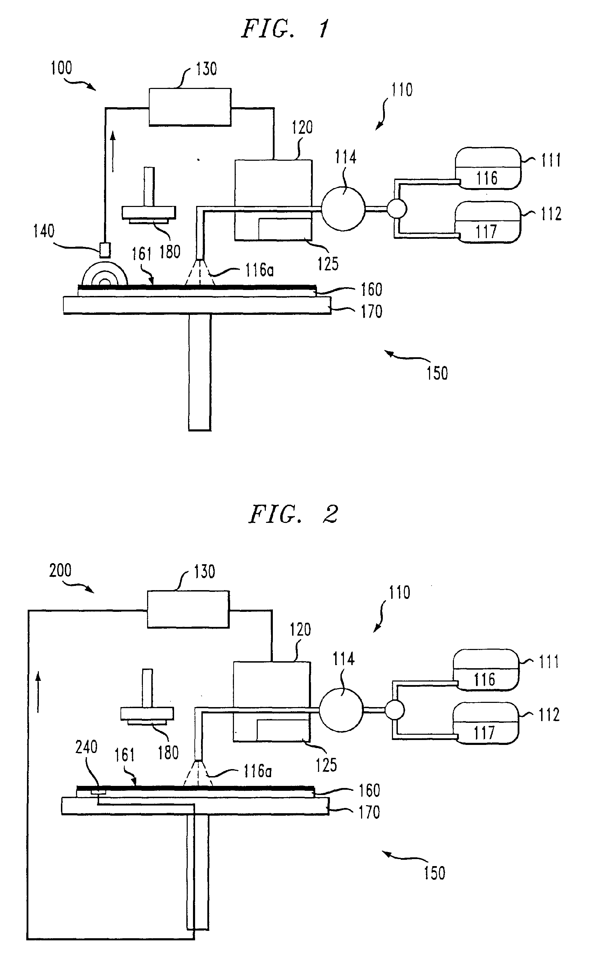

Referring now to FIGURE 1, illustrated is a partial sectional view of one embodiment of a polishing surface temperature conditioning apparatus 100 constructed according to the principles of the present invention. In an advantageous embodiment, the polishing surface temperature conditioning apparatus 100 comprises a fluid delivery system 110, a heat exchanger 120, a heater 125, a controller 130, and a temperature sensor 140. The polishing surface temperature conditioning apparatus 100 is intended for use with a polishing system 150 having a polishing surface 161, such as a conventional polishing pad 160, and a polishing platen 170. In one advantageous embodiment, the polishing system 150 may be a chemical/mechanical polishing system for planarizing semiconductor wafers. One who is skilled in the art will recognize that the heat exchanger 120, heater 125 and controller 130 may be incorporated in a single unit.

In one exemplary embodiment, the fluid delivery system 110 comprises a first fluid supply 111, a second fluid supply 112, a pump 114, first fluid 116 and a second fluid 117. The first fluid 116 may be a rinse 116 and the second fluid 117 may be a polishing slurry 117. The fluid delivery system 110 is coupled to the polishing system 150 and is configured to deliver either the first fluid 116 or the second fluid 117 to a polishing surface 161 of the polishing pad 160.

The temperature sensor 140 is coupled to the controller 130 and may be an infrared sensor, a thermocouple, a thermistor, a pyrometer, a liquid/glass thermometer, a pressure thermometer, a resistance thermometer, or a linear quartz thermometer. In the illustrated embodiment, the temperature sensor 140 is shown as a passive infrared sensor. However, the choice of which type of temperature sensor 140 is to be used in a specific application will be dictated by the environment expected for both the pre-polishing conditions and the intended polishing conditions. One who is skilled in the art is familiar with the employment of these types of thermal sensors. The temperature sensor 140 provides information as to the temperature T_{S} of the polishing surface 161.

During operation, the surface temperature T_{S} is detected by the temperature sensor 140 and is forwarded to the controller 130. The controller 130 determines that the surface temperature T_{S} is below a desired temperature T_{SD} for the intended process and commands the heater 125 to input heat to the heat exchanger 120. The heater 125 may be of conventional design that provides the necessary heat to raise the temperature T_{F} of the fluid 116 passing through the heat exchanger 120. Fluid 116 is pumped from the first fluid supply 111 by the pump 114 to the heat exchanger 120 and then to the polishing surface 161. In the heat exchanger 120, heat is transferred to the first fluid 116, creating a first heated fluid 116a. The first heated fluid 116a is delivered to the polishing surface 161 where the heated fluid 116a at a temperature T_{F} raises the surface temperature T_{S} of the polishing surface 161 to a desired temperature T_{D}. The fluid temperature T_{F} is chosen to effect the desired surface temperature T_{SD}. When heated to the fluid temperature T_{F}, the temperature conditioning rinse 116a will cause conduction heating of the polishing surface 161 such that the desired surface temperature T_{SD} is achieved. When the temperature sensor 140 detects the desired surface temperature T_{SD}, the controller 130 directs the heater 125 to stop heating the fluid 116. Any subsequent decrease in the actual surface temperature T_{S} from the desired surface temperature T_{SD} will be sensed by the temperature senor 140 and cause the controller 130 to command the heater 125 to inject heat into the heat exchanger 120 to heat the fluid 116.

The first fluid 116 may be a temperature conditioning rinse and the second fluid 117 may be a polishing slurry. To conserve expensive polishing slurry, a temperature conditioning rinse of a relatively inexpensive fluid, such as deionized water, may be used. The fluid supply 110 may incorporate both fluid sources, e.g., deionized water and slurry, that may interchangeably be pumped to the heat exchanger 120. The slurry 117 for the actual process may also be appropriately heated or cooled with the aid of the heat exchanger 120. Thus, the polishing surface 161 of the polishing pad 160 is brought to an efficient process temperature T_{SD} that is chosen for the type of chemical/mechanical planarization process to be performed by using an inexpensive heated fluid 116. The slurry 117 may then be introduced at a slurry temperature that maintains the optimal pad surface temperature T_{SD} during planarization. In a typical planarization of a metal layer of a semiconductor wafer 180, the pad surface temperature Ts must be raised above ambient. In a particularly advantageous embodiment, this apparatus may be used to raise the polishing surface temperature Tₛ for the planarization of tungsten.

Referring now to FIGURE 2, illustrated is a partial sectional view of an alternative embodiment of the polishing surface temperature conditioning apparatus of FIGURE 1. In this embodiment, a polishing surface conditioning apparatus 200 comprises the fluid delivery system 110, heat exchanger 120, and controller 130 of FIGURE 1 and additionally a chiller 225 and a temperature sensor 240. The chiller 225 performs the inverse function of the heater 125 of FIGURE 1 by removing heat from the fluids 116, 117 for those instances where a lower surface temperature than ambient is required to efficiently planarize a semiconductor wafer 180. The temperature sensor 240 as shown may be a thermistor 240 embedded in the polishing surface 160 and coupled through the polishing platen 170 of the polishing system 150. One who is skilled in the art is familiar with the installation and use of thermistors and other direct contact temperature sensors.

Thus, embodiments of a polishing surface temperature conditioning apparatus have been described that incorporate a heat exchanger to selectively heat or cool a fluid to a temperature that will effect a desired polishing surface temperature when the fluid is delivered to the polishing surface. Significant cost savings may be experienced by using an inexpensive rinse fluid such as deionized water to raise/lower the polishing surface temperature prior to commencing planarization operations. Additionally, provisions have been made to heat/cool the polishing slurry to retain optimum conditions during the polishing.

Although the present invention has been described in detail, those skilled in the art should understand that they can make various changes, substitutions and alterations herein without departing from the spirit and scope of the invention in its broadest form.

## Claims

1. For use with a polishing system having a polishing surface associated therewith, a polishing surface temperature conditioning apparatus, comprising:
a fluid delivery system coupled to the polishing system and configured to deliver a fluid to a polishing surface; and
a heat exchanger coupled to the fluid delivery system and configured to control a fluid temperature of the fluid, the fluid temperature chosen to effect a surface temperature of the polishing surface.

2. The polishing surface temperature conditioning apparatus as recited in Claim 1 wherein the heat exchanger includes a controller configured to control the fluid temperature.

3. The polishing surface temperature conditioning apparatus as recited in Claim 1 further comprising a temperature sensor coupled to the polishing surface and the heat exchanger, the temperature sensor configured to sense the surface temperature.

4. The polishing surface temperature conditioning apparatus as recited in Claim 3 wherein the temperature sensor is selected from the group consisting of:
an infrared sensor;
a thermocouple;
a thermistor;
a pyrometer;
a liquid/glass thermometer;
a pressure thermometer;
a resistance thermometer; and
a linear quartz thermometer.

5. The polishing surface temperature conditioning apparatus as recited in Claim 1 wherein the heat exchanger includes a heater configured to transfer heat to the heat exchanger and the fluid.

6. The polishing surface temperature conditioning apparatus as recited in Claim 1 wherein the heat exchanger includes a chiller configured to transfer heat from the heat exchanger and the fluid.

7. The polishing surface temperature conditioning apparatus as recited in Claim 1 wherein the fluid is a temperature conditioning rinse or a slurry.

8. A semiconductor wafer polishing system, comprising:
a polishing apparatus having a polishing surface associated therewith; and
a polishing surface temperature conditioning apparatus having:
a fluid delivery system coupled to the polishing system and configured to deliver a fluid to a polishing surface of the polishing surface; and
a heat exchanger coupled to the fluid delivery system and configured to control a fluid temperature of the fluid, the fluid temperature chosen to effect a surface temperature of the polishing surface.

9. The semiconductor wafer polishing system as recited in Claim 8 wherein the heat exchanger includes a controller configured to control the fluid temperature.

10. The semiconductor wafer polishing system as recited in Claim 8 further comprising a temperature sensor coupled to the polishing surface and the heat exchanger, the temperature sensor configured to sense the surface temperature.

11. The semiconductor wafer polishing system as recited in Claim 10 wherein the temperature sensor is selected from the group consisting of:
an infrared sensor;
a thermocouple;
a thermistor;
a pyrometer;
a liquid/glass thermometer;
a pressure thermometer;
a resistance thermometer; and
a linear quartz thermometer.

12. The semiconductor wafer polishing system as recited in Claim 8 wherein the heat exchanger includes a heater configured to transfer heat to the heat exchanger and the fluid.

13. The semiconductor wafer polishing system as recited in Claim 8 wherein the heat exchanger includes a chiller configured to transfer heat from the heat exchanger and the fluid.

14. The semiconductor wafer polishing system as recited in Claim 8 wherein the fluid is a temperature conditioning rinse or a slurry.

15. A method of manufacturing an integrated circuit, comprising:
forming active devices on a semiconductor wafer;
forming interconnects that connect the active devices to form an operative integrated circuit; and
polishing a substrate located on the semiconductor wafer against a polishing surface, including:
effecting a surface temperature of the polishing surface by effecting a fluid temperature of a fluid with a heat exchanger; and
delivering the fluid to the polishing surface.

16. The method as recited in Claim 15 wherein effecting a fluid temperature includes effecting a fluid temperature with a heat exchanger including a controller configured to control the fluid temperature.

17. The method as recited in Claim 15 wherein effecting a surface temperature includes effecting a surface temperature by sensing the surface temperature with a temperature sensor coupled to the polishing surface and to the controller.

18. The method as recited in Claim 17 wherein effecting a surface temperature includes effecting a surface temperature by sensing the surface temperature with a temperature sensor selected from the group consisting of:
an infrared sensor;
a thermocouple;
a thermistor;
a pyrometer;
a liquid/glass thermometer;
a pressure thermometer;
a resistance thermometer; and
a linear quartz thermometer.

19. The method as recited in Claim 15 wherein effecting a surface temperature includes effecting a surface temperature with a heater configured to transfer heat to the heat exchanger and the fluid.

20. The method as recited in Claim 15 wherein effecting a surface temperature includes effecting a surface temperature with a chiller configured to transfer heat from the heat exchanger and the fluid.

21. The method as recited in Claim 15 wherein effecting a fluid temperature of a fluid includes effecting a fluid temperature of a temperature conditioning rinse or slurry.

22. The method as recited in Claim 15 wherein forming interconnects includes forming interconnects comprising a metal.

23. The method as recited in Claim 22 wherein forming interconnects includes forming interconnects comprising tungsten.
